Europäisches Patentamt

European Patent Office

Office européen des brevets

(11) Numéro de publication: **0 307 276 B1**

## FASCICULE DE BREVET EUROPEEN

(45) Date de publication de fascicule du brevet: **03.11.93** (51) Int. Cl.5: **H03H  19/00**

(21) Numéro de dépôt: **88402152.8**

(22) Date de dépôt: **24.08.88**

(54) **Dispositif de filtre échantillonné à capacités commutées.**

(30) Priorité: **26.08.87 FR 8711961**

(43) Date de publication de la demande:
**15.03.89 Bulletin  89/11**

(45) Mention de la délivrance du brevet:
**03.11.93 Bulletin  93/44**

(84) Etats contractants désignés:
**DE FR GB IT NL**

(56) Documents cités:

ELECTRONICS LETTERS, vol. 21, no. 2, 17
janvier 1985, pages 79-80, Stevenage, Herts,
GB; H. BAHER: "Synthesis of highpass
switched-capacitor LDI filters"

ELECTRONICS LETTERS, vol. 21, no. 11, 23
mai 1985, pages 484-485, Stevenage, Herts,
GB; S. ERIKSSON: "SC filter circuit with decimation of sampling frequency"

FREQUENZ, vol. 35, no. 3/4, mars-avril 1981,
pages 93-95, Berlin, DE; P. LUTZ: "Real terminations of SC-filters using LDI-integrators

PROCEEDINGS OF THE IEEE, vol. 75, no. 7,
juillet 1987, pages 957-960, New York, US;

P.V. ANANDA MOHAN: "New structures for
MOSFET-C filters"

(73) Titulaire: **FRANCE TELECOM
6, Place d'Alleray
F-75015 Paris(FR)**

(72) Inventeur: **Tawfik, Mohamed Sameh
150, Galerie de l'Arlequin
F-38100 Grenoble(FR)**
Inventeur: **Senn, Patrice
13, Grande Rue
F-38000 Grenoble(FR)**

(74) Mandataire: **Netter, André et al
Cabinet NETTER,
40, rue Vignon
F-75009 Paris (FR)**

EP 0 307 276 B1

# Description

La présente invention concerne la réalisation de filtres échantillonnés à capacités commutées. Plus particulièrement, elle a pour objet la réalisation de filtres échantillonnés à capacités commutées du type passe-haut. Elle trouve une application en télécommunication dans la fabrication sous la forme de circuits intégrés de filtres échantillonnés à capacités commutées.

D'une façon générale, la réalisation de filtres échantillonnés à capacités commutées utilise une structure dite en échelle dont les éléments de base sont des intégrateurs de type LDI pour "Lossless Discrete Integrator" (Intégrateur discret sans pertes) en ce qui concerne les filtres passe-bas ou des dérivateurs de type LDD pour "Lossless Discrete Differenciator" (Dérivateur discret sans pertes) en ce qui concerne les filtres passe-haut. Le document "Electronics Letter", vol 21, no 2, 17 janvier 1985, p 79-80 "Synthesis of highpass swiched capacitor LDI filter" divulgue un exemple d'un tel filtre

Ces éléments de base comprennent des capacités, des interrupteurs et un seul amplificateur. L'ordre du filtre échantillonné est égal au nombre d'amplificateurs, c'est-à-dire égal au nombre d'intégrateurs LDI ou de dérivateurs LDD. Un filtre échantillonné à capacités commutées utilisant des intégrateurs LDI a l'avantage de s'affranchir des capacités parasites et de mieux s'adapter au circuit intégré que les dérivateurs LDD. Malheureusement, un filtre à intégrateur LDI n'est pas satisfaisant dans la bande de fréquence de filtrage des filtres passe-haut puisqu'il présente des problèmes d'instabilité liés à l'utilisation d'un graphe de fluence, c'est-à-dire le graphe permettant le calcul des éléments capacitifs du filtre, dont l'approche ne prend pas en compte les effets de terminaison propres aux filtres passe-haut. En d'autres termes, le graphe de fluence des intégrateurs LDI s'adapte bien à la réalisation de filtres de type passe-bas mais ne s'applique pas correctement à la réalisation de filtres de type passe-haut.

Pour résoudre ce problème, l'article "SC MODIFIED LOSSLESS DISCRETE DIFFERENTIATORS AND RESULTING SC HIGHPASS LADDER FILTERS", Electronic Letters, 16 Janvier 1986, pages 97-99, propose une méthode utilisant une transformation MLDD pour "Modified Lossless Discrete Differenciator" (Dérivateur discret modifié sans pertes) permettant d'obtenir un filtre échantillonné à capacités commutées de type passe-haut. La cellule de base est un dérivateur de type LDD modifié et agencé en filtre passe-haut. L'utilisation d'un dérivateur LDD permet d'obtenir un filtre échantillonné très stable et peu sensible puisque son graphe de fluence s'applique bien à la bande de fréquence de filtrage des filtres passe-haut. Néanmoins, l'inconvénient de ce genre de dispositif est que la transformée linéaire dite en Z de la cellule permettant de passer du domaine des fréquences continues au domaine des fréquences échantillonnées, comporte un terme d'ordre 2, c'est-à-dire que, par exemple, pour un filtre échantillonné d'ordre 3, il faut six amplificateurs opérationnels.

Un tel dispositif n'est donc pas satisfaisant car il comporte un nombre trop élevé d'opérateurs, ce qui élève d'autant le coût de sa réalisation. Par ailleurs, la performance du filtre est réduite car il comporte une capacité très sensible aux capacités parasites puisqu'elle est commutée de façon bipolaire. Enfin, le calcul de tous les éléments du filtre à partir de son gabarit prédéterminé, c'est-à-dire la méthode de synthèse du filtre, est approximatif puisqu'il n'est valable en ce qui concerne la réalisation de filtres passe-haut que pour des fréquences d'échantillonnage élevées, ce qui nécessite l'utilisation d'amplificateurs différentiels ayant un produit gain-bande passante élevé.

On connaît dans le domaine du filtrage numérique une méthode qui inverse la polarité de la transformée en Z de type LDD d'une cellule de base pour obtenir un filtre numérique de type passe-haut. Cette méthode utilise la synthèse du filtre passe-bas de type LDI en changeant quelques signes dans le circuit du filtre numérique de base. Ces changements de signes s'effectuent facilement en modifiant par exemple le signe d'un additionneur. Malheureusement, cette méthode utilisée en filtrage numérique est difficilement applicable en filtrage échantillonné car elle pose des problèmes technologiques difficiles à résoudre. Notamment, jusqu'à présent, le changement de signe de la transformée en Z d'un filtre échantillonné exige des opérations compliquées technologiquement et utilise de nombreux opérateurs, capacités et interrupteurs. Il en résulte une augmentation des coûts de la fabrication de tels filtres sous la forme de circuits intégrés.

La présente invention a justement pour but d'apporter une solution à ces problèmes. A cette fin, elle propose un dispositif permettant de transposer la bande de fréquence de filtrage d'un filtre échantillonné à capacités commutées, c'est-à-dire par exemple de transformer un filtre échantillonné à capacités commutées de type passe-bas en un filtre échantillonné à capacités commutées de type passe-haut. L'invention porte sur un dispositif du type comprenant au moins une cellule de base agencée en filtre échantillonné à capacités commutées, ainsi qu'une horloge propre à définir deux états différents pour commander l'échantillonnage.

Selon une définition générale de l'invention, le dispositif comprend :

- des moyens amont de commutation aptes à inverser la polarité du signal d'entrée de la cellule pendant l'un des deux états,
- des moyens aval de commutation aptes à inverser le signal de sortie de la cellule; ce qui permet de transposer la bande de fréquence de filtrage de la cellule.

Plus particulièrement, la cellule de base est agencée en filtre échantillonné de type passe-bas, le dispositif étant alors un filtre échantillonné de type passe-haut.

Selon un aspect de l'invention, la cellule de base comprend :

- un premier amplificateur différentiel dont l'entrée négative est reliée via une première capacité à la sortie dudit premier amplificateur délivrant le signal de sortie de la cellule et dont l'entrée positive est à la masse;
- un premier interrupteur relié à une armature d'une seconde capacité, ledit premier interrupteur étant propre sur commande de l'horloge à établir une liaison électrique entre ladite seconde capacité et l'entrée négative du premier amplificateur ou entre ladite seconde capacité et la masse; et
- un second interrupteur relié à l'autre armature de la seconde capacité, ledit second interrupteur étant propre, sur commande de l'horloge, à établir une liaison électrique entre ladite seconde capacité et la borne positive de la cellule de base ou entre ladite seconde capacité et la borne négative de la cellule de base recevant le signal d'entrée de la cellule.

Selon une autre caractéristique de l'invention, les moyens amont de commutation comprennent :

- un troisième interrupteur relié à la borne positive de la cellule de base, ledit troisième interrupteur étant propre, sur commande de l'horloge, à établir une liaison électrique entre ladite borne positive et la masse ou entre ladite borne positive et le signal d'entrée; et
- un quatrième interrupteur relié à la borne négative de la cellule de base, ledit quatrième interrupteur étant propre, sur commande de l'horloge, à établir une liaison électrique entre ladite borne négative et la masse ou entre ladite borne négative et le signal d'entrée de la cellule.

Selon encore une autre caractéristique de l'invention, les moyens aval de commutation comprennent :

- un second amplificateur différentiel, du type inverseur, propre sur commande de l'horloge à inverser la polarité du signal de sortie du dispositif pendant l'autre des deux états;
- un cinquième interrupteur relié à la sortie du premier amplificateur différentiel de la cellule, ledit cinquième interrupteur étant propre sur commande de l'horloge à établir une liaison électrique entre ladite sortie du premier amplificateur différentiel et un premier noeud ou entre ladite sortie du premier amplificateur et l'entrée du second amplificateur opérationnel; et

- un sixième interrupteur relié à la sortie du dispositif, ledit sixième interrupteur étant propre sur commande de l'horloge à établir une liaison électrique entre ladite sortie du dispositif et la sortie du second amplificateur opérationnel ou entre ladite sortie du dispositif et le premier noeud.

Les moyens amont et aval de commutation selon l'invention permettent de réaliser simplement et efficacement la transposition de la bande de fréquence de filtrage des filtres échantillonnés à capacités commutées. Ces moyens amont et aval de commutation peuvent être réalisés sous la forme de modules facilement définissables et interchangeables. Il en résulte une fabrication plus aisée et moins onéreuse des filtres échantillonnés sous la forme de circuits intégrés.

Selon un mode de réalisation préféré de l'invention, les moyens aval de commutation sont agencés en étage échantillonneur-bloqueur, l'étage comprenant un huitième interrupteur relié à la sortie de la cellule de base via un septième interrupteur propre sur commande à établir une liaison électrique entre la sortie de la cellule et le huitième interrupteur, ledit huitième interrupteur étant propre sur commande de l'horloge à établir une liaison électrique entre ledit septième interrupteur et l'entrée négative d'un troisième amplificateur différentiel ou entre ledit septième interrupteur et l'entrée positive dudit troisième amplificateur, le signal de sortie du dispositif étant obtenu à la sortie du troisième amplificateur différentiel.

Selon une variante de l'invention, la cellule de base est à double échantillonnage.

Selon un mode de réalisation préféré de la variante de l'invention, les moyens aval de commutation comprennent :

- un neuvième interrupteur relié à la sortie de la cellule de base, ledit neuvième interrupteur étant propre sur commande de l'horloge à établir une liaison électrique entre ladite sortie de la cellule et un second noeud ou entre ladite sortie de la cellule et un troisième noeud;
- un dixième interrupteur relié à l'entrée positive d'un quatrième amplificateur différentiel, ledit dixième interrupteur étant propre sur commande de l'horloge à établir une liaison électrique entre ladite entrée positive et la masse ou entre ladite entrée positive et le second noeud;

- une troisième capacité placée entre le troisième noeud et l'entrée négative du quatrième amplificateur différentiel, la troisième capacité ayant en parallèle un onzième interrupteur propre sur commande de l'horloge à établir une liaison électrique entre les deux armatures de la troisième capacité;
- une quatrième capacité placée entre l'entrée négative du quatrième amplificateur et la sortie dudit quatrième amplificateur délivrant le signal de sortie du dispositif, ladite quatrième capacité ayant en parallèle un douzième interrupteur propre sur commande de l'horloge à établir une liaison électrique entre les deux armatures de la quatrième capacité.

Selon un autre aspect de la variante de l'invention, les moyens amont de commutation sont agencés en étages échantillonneurs-bloqueurs.

Selon une autre caractéristique de la seconde variante de l'invention, les moyens aval de commutation comprennent :

- un treizième interrupteur relié à la sortie de la cellule, ledit treizième interrupteur étant propre sur commande de l'horloge à établir une liaison électrique entre ladite sortie de la cellule et un quatrième noeud;
- un quatorzième interrupteur relié au quatrième noeud, ledit quatorzième interrupteur étant propre sur commande de l'horloge à établir une liaison électrique entre ledit quatrième noeud et un cinquième noeud ou entre ledit quatrième noeud et un sixième noeud;
- un quinzième interrupteur relié à l'entrée positive d'un cinquième amplificateur différentiel, ledit quinzième interrupteur étant propre sur commande de l'horloge à établir une liaison électrique entre ladite entrée positive et la masse ou entre ladite entrée positive et le cinquième noeud;
- une cinquième capacité placée entre le sixième noeud et l'entrée négative du cinquième amplificateur opérationnel, ladite cinquième capacité ayant en parallèle un seizième interrupteur propre sur commande de l'horloge à établir une liaison électrique entre les deux armatures de la cinquième capacité;
- une sixième capacité placée entre l'entrée négative du cinquième amplificateur opérationnel et la sortie dudit cinquième amplificateur délivrant le signal de sortie du dispositif, ladite sixième capacité ayant en parallèle un dix-septième interrupteur propre sur commande de l'horloge à établir une liaison électrique entre les deux armatures de la sixième capacité;
- une septième capacité dont une armature est reliée au sixième noeud et dont l'autre armature est reliée à la masse; et

- une huitième capacité dont une armature est reliée à l'entrée positive du cinquième amplificateur différentiel et dont l'autre armature est reliée à la masse.

D'autres caractéristiques et avantages de l'invention apparaîtront à l'examen de la description détaillée ci-après, et des dessins annexés sur lesquels :

- la figure 1 représente schématiquement une cellule de base agencée en filtre échantillonné à capacités commutées de type passe-bas selon l'art antérieur;
- la figure 2 représente schématiquement la cellule de base décrite en référence à la figure 1 dans laquelle sont ajoutés des moyens amont et aval de commutation selon l'invention;
- la figure 3 représente des chronogrammes illustrant le fonctionnement du dispositif décrit en référence à la figure 2 selon l'invention;
- la figure 4 est un exemple de vue symbolique du dispositif décrit en référence à la figure 2 selon l'invention;
- la figure 5 représente un exemple du dispositif selon l'invention dans lequel les moyens aval de commutation comprennent un étage échantillonneur-bloqueur;
- la figure 6 représente des chronogrammes illustrant le fonctionnement du dispositif décrit en référence à la figure 5 selon l'invention;
- la figure 7 représente schématiquement une variante du dispositif de l'invention dans laquelle la cellule de base est à double échantillonnage selon l'invention; et
- la figure 8 représente schématiquement un filtre échantillonné à capacités commutées du type passe-haut elliptique selon l'invention.

Les dessins annexés comportent à de nombreux titres des éléments de caractère certain. Ils pourront donc non seulement servir à éclairer la description ci-après, mais aussi contribuer à la définition de l'invention, le cas échéant.

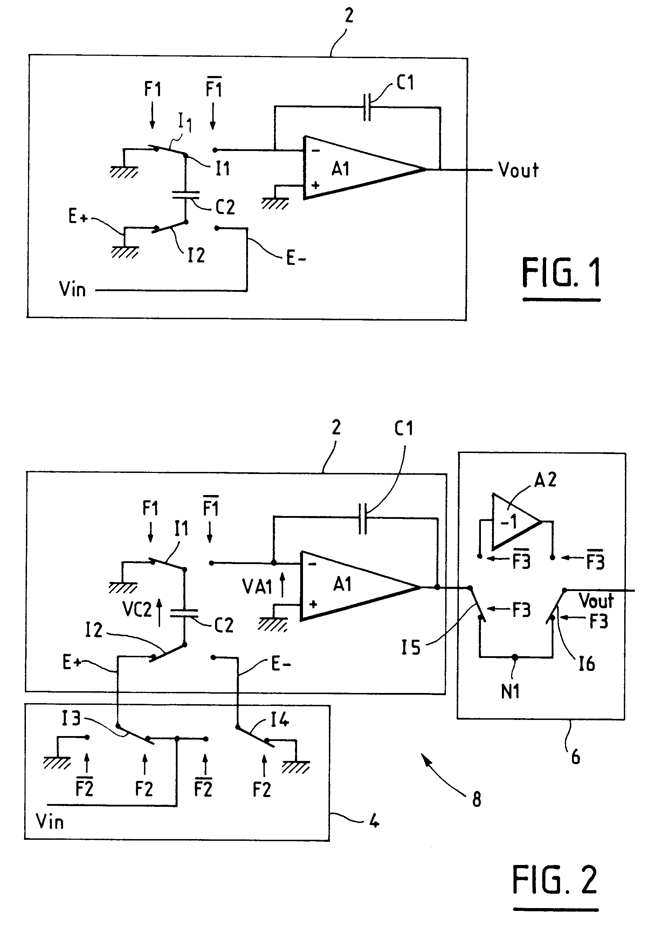

Sur la figure 1, la référence 2 désigne une cellule de base du dispositif de filtre échantillonné à capacités commutées.

La céllule de base 2 comprend tout d'abord un amplificateur différentiel $A_1$. L'entrée négative de l'amplificateur différentiel $A_1$ est reliée via une capacité $C_1$ à la sortie de l'amplificateur $A_1$ délivrant le signal de sortie $V_{out}$ de la cellule de base 2. L'entrée positive de l'opérateur $A_1$ est à la masse.

Un interrupteur $I_1$ est relié à une armature d'une capacité $C_2$. Un signal d'horloge de fréquence $F_1$ comprenant un état haut pendant $F_1$ et un état bas pendant $\overline{F_1}$ commande l'ouverture et la fermeture de l'interrupteur $I_1$. Par exemple, pen-

dant $\overline{F_1}$, l'interrupteur $I_1$ établit une liaison électrique entre la seconde capacité $C_2$ et l'entrée négative de l'amplificateur différentiel $A_1$ tandis que pendant $F_1$ l'interrupteur $I_1$ établit une liaison électrique entre ladite seconde capacité $C_2$ et la masse.

Un interrupteur $I_2$ est relié à l'autre armature de la capacité $C_2$. L'ouverture et la fermeture de l'interrupteur $I_2$ sont commandées aussi par le signal d'horloge de fréquence $F_1$. Par exemple, pendant $F_1$, l'interrupteur $I_2$ établit une liaison électrique entre la borne positive $E^+$ de la cellule et la seconde capacité $C_2$ tandis que pendant $\overline{F_1}$, l'interrupteur $I_2$ établit une liaison électrique entre la borne négative $E^-$ de la cellule de base 2 et ladite seconde capacité $C_2$. Le signal d'entrée $V_{in}$ de la cellule de base 2 est relié à la borne négative $E^-$ de la cellule de base 2.

Ainsi agencée, la cellule de base 2 se comporte en filtre échantillonné à capacités commutées de type passe-bas. Cette cellule de base 2 est un intégrateur de type LDI dont la transformée dite en Z permettant de passer du domaine des fréquences continues au domaine des fréquences échantillonnées a pour expression :

$$P \rightarrow 2F_e(Z^{1/2} - Z^{-1/2})$$

dans laquelle P est le domaine des fréquences continues et $F_e$ est la fréquence d'échantillonnage.

Sur la figure 2, on voit une cellule de base 2 décrite en référence à la figure 1, dans laquelle sont ajoutés des moyens amont 4 et aval 6 de commutation selon l'invention.

La cellule de base 2 est identique à celle décrite en référence à la figure 1.

Les moyens amont 4 de commutation comprennent tout d'abord un interrupteur $I_3$ relié à la borne positive $E^+$ de la cellule de base, l'ouverture et la fermeture de l'interrupteur $I_3$ sont commandées par un signal d'horloge de fréquence $F_2$ dont la pulsation est le double de celle de la fréquence du signal d'horloge $F_1$ décrit en référence à la figure 1. Par exemple, pendant $\overline{F_2}$, l'interrupteur $I_3$ établit une liaison électrique entre la borne positive $E^+$ de la cellule et la masse tandis que pendant $F_2$, l'interrupteur $I_3$ établit une liaison électrique entre la borne positive et le signal d'entrée de la cellule $V_{in}$.

Les moyens amont 4 de commutation comprennent enfin un interrupteur $I_4$ relié à la borne négative $E^-$ de la cellule de base 2. L'ouverture et la fermeture de l'interrupteur $I_4$ sont commandées par le signal d'horloge de fréquence $F_2$. Par exemple, pendant $\overline{F_2}$, l'interrupteur $I_4$ établit une liaison électrique entre la borne négative $E^-$ de la cellule de base 2 et le signal d'entrée de ladite cellule tandis que pendant $\overline{F_2}$, l'interrupteur $I_4$ établit une

liaison électrique entre ladite borne négative $E^-$ et la masse.

Les moyens aval 6 de commutation comprennent tout d'abord un interrupteur $I_5$ relié à la sortie de l'amplificateur différentiel $A_1$ de la cellule de base 2. L'ouverture et la fermeture de l'interrupteur $I_5$ sont commandées par un signal d'horloge de fréquence $F_3$, de pulsation identique à la fréquence $F_2$ mais décalée d'une demi-période. Par exemple, pendant $F_3$, l'interrupteur $I_5$ établit une liaison électrique entre la sortie de l'amplificateur $A_1$ et un noeud $N_1$ tandis que pendant $F_3$, l'interrupteur $I_5$ établit une liaison électrique entre la sortie de l'amplificateur $A_1$ et l'entrée d'un amplificateur différentiel $A_2$ de type inverseur.

Enfin, un interrupteur $I_6$ est placé à la sortie de l'amplificateur différentiel $A_2$. L'ouverture et la fermeture de l'interrupteur $I_6$ sont commandées par un signal d'horloge de fréquence $F_3$. Pendant $F_3$, l'interrupteur $I_6$ établit une liaison électrique entre le noeud $N_1$ et la sortie $V_{out}$ du dispositif tandis que pendant $\overline{F_3}$, l'interrupteur $I_6$ établit une liaison électrique entre la sortie de l'amplificateur opérationnel $A_2$ et la sortie $V_{out}$ du dispositif. Le dispositif 8 comprenant la cellule de base 2 sur laquelle sont ajoutés les moyens 4 et 6 est alors un filtre échantillonné du type passe-haut dont la transformée dite en Z permettant de passer du domaine des fréquences continues au domaine des fréquences échantillonnées a pour expression :

$$P \rightarrow 2F_e(Z^{1/2} + Z^{-1/2})$$

dans laquelle P est le domaine des fréquences continues et dans laquelle $F_e$ est la fréquence d'échantillonnage.

La caractéristique essentielle et nouvelle du dispositif de l'invention est d'associer à cette cellule de base 2 agencée en filtre passe-bas comprenant un intégrateur de type LDI, des moyens amont et aval permettant de transposer la bande de fréquence de filtrage de la cellule de base pour obtenir un filtre passe-haut.

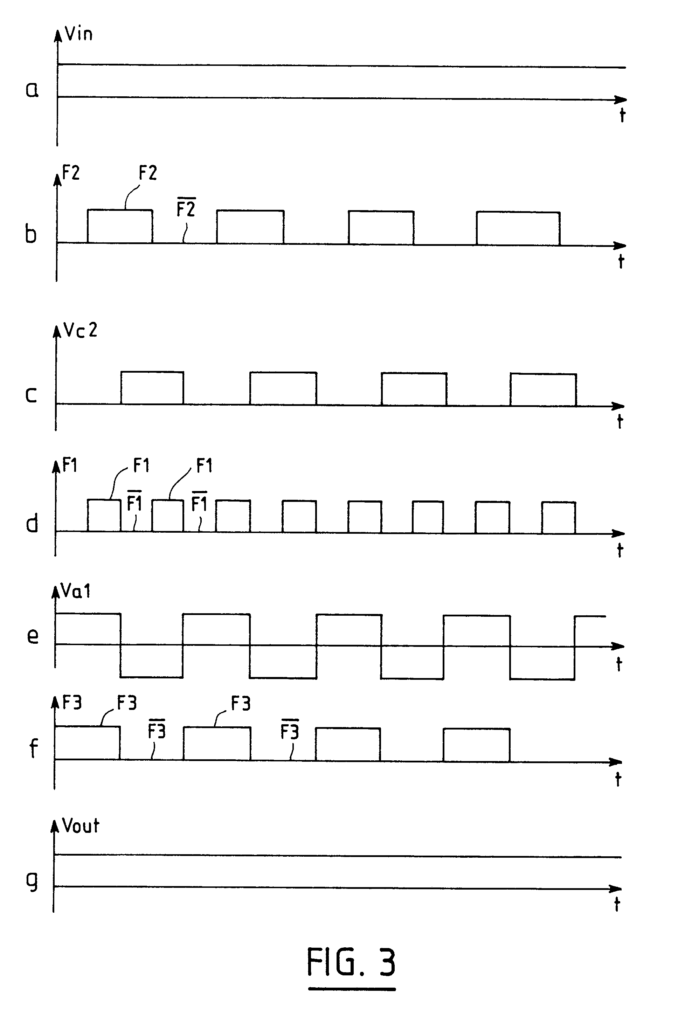

Sur la figure 3, on a représenté les chronogrammes illustrant le fonctionnement du dispositif décrit en référence à la figure 2.

La partie a de la figure 3 représente le signal d'entrée $V_{in}$ du dispositif appliqué aux moyens amont 4 de commutation. Le signal $V_{in}$ est un signal continu.

La partie b de la figure 3 représente le signal d'horloge de fréquence $F_2$ propre à commander l'ouverture et la fermeture des interrupteurs $I_3$ et $I_4$. Le signal d'horloge $F_2$ a périodiquement un état haut appelé $F_2$ et un état bas appelé $\overline{F_2}$.

La partie c de la figure 3 représente la tension $V_{c2}$ aux bornes de la capacité $C_2$.

La partie d de la figure 3 représente le signal d'horloge de fréquence $F_1$ propre à commander l'ouverture et la fermeture des interrupteurs $I_1$ et $I_2$. Le signal d'horloge $F_1$ a périodiquement un état haut appelé $F_1$ et un état bas appelé $\overline{F_1}$. Le signal d'horloge $F_1$ a une période deux fois plus courte que celle du signal d'horloge $F_2$.

La partie e de la figure 3 représente le signal $v_{a1}$ aux bornes de l'amplificateur différentiel $A_1$.

La partie f de la figure 3 représente le signal d'horloge de fréquence $F_3$ propre à commander l'ouverture et la fermeture des interrupteurs $I_5$ et $I_6$. Le signal d'horloge $F_3$ a périodiquement un état haut appelé $F_3$ et un état bas appelé $\overline{F_3}$.

Enfin, la partie g de la figure 3 représente le signal de sortie $V_{out}$ du dispositif de l'invention. Le signal de sortie est un signal continu.

Au premier état haut $F_2$, l'interrupteur $I_4$ est à la masse tandis que l'interrupteur $I_3$ établit une liaison électrique entre le signal $V_{in}$ et l'entrée $E^+$. Le signal $V_{in}$ arrive à l'entrée $E^+$ et traverse la capacité $C_2$. Au premier état haut $F_1$, l'interrupteur $I_1$ établit une liaison électrique entre la capacité $C_2$ et la masse; le signal d'entrée est relié ainsi via $I_3$, $E^+$, $C_2$ et $I_1$ à la masse. Il en résulte une tension $V_{c2}$ et une tension $V_{a1}$ nulles. Au premier état bas $\overline{F_1}$ suivant, l'interrupteur $I_1$ établit une liaison électrique entre la capacité $C_2$ et l'entrée négative de l'amplificateur $A_1$. La capacité $C_2$ se charge au signal d'entrée $V_{in}$, la tension $V_{c2}$ est donc égale à $V_{in}$. La tension $V_{a1}$ est également égale au signal d'entrée $V_{in}$ mais de polarité inverse puisque la capacité $C_2$ est reliée à l'entrée négative de l'amplificateur $A_1$.

Au premier état bas $\overline{F_2}$, l'interrupteur $I_3$ est à la masse, tandis que l'interrupteur $I_4$ établit une liaison électrique entre le signal d'entrée et l'entrée $E^-$, le signal $V_{in}$ arrive donc à l'entrée $E^-$ et traverse la capacité $C_2$. Au second état haut $F_1$, l'interrupteur $I_2$ n'établit pas de liaison électrique entre $C_2$, $E^-$ et le signal $V_{in}$. La tension aux bornes de la capacité $C_2$ est maintenue à la tension du signal $V_{in}$.

Au second état bas $\overline{F_1}$ suivant, l'interrupteur $I_2$ établit une liaison électrique entre le signal $V_{in}$ et la capacité $C_2$ ainsi qu'une liaison électrique entre la capacité $C_2$ et l'entrée négative de l'amplificateur $A_1$. Il en résulte une décharge de la capacité $C_2$ dans la capacité $C_1$. La tension aux bornes de la capacité $C_2$ est maintenant nulle tandis que la tension aux bornes de l'amplificateur $A_1$ est égale à la tension du signal d'entrée $V_{in}$.

Pendant le premier état haut $F_3$, les interrupteurs $I_5$ et $I_6$ établissent une liaison électrique entre la sortie de l'amplificateur $A_1$ et la sortie du dispositif. Le signal de sortie du dispositif est ainsi égale à la sortie de l'amplificateur $A_1$.

Pendant le premier état bas $\overline{F_3}$, les interrupteurs $I_5$ et $I_6$ établissent une liaison électrique entre la sortie de l'amplificateur $A_1$ et l'amplificateur $A_2$ de type inverseur. Le signal de sortie du dispositif est ainsi égal au signal de sortie de l'amplificateur $A_1$ mais de polarité inverse. Enfin, l'inversion des signaux d'entrée et de sortie du dispositif 8 se reproduisent périodiquement à la cadence des signaux d'horloge de fréquence $F_1$, $F_2$ et $F_3$ comme décrit ci-avant.

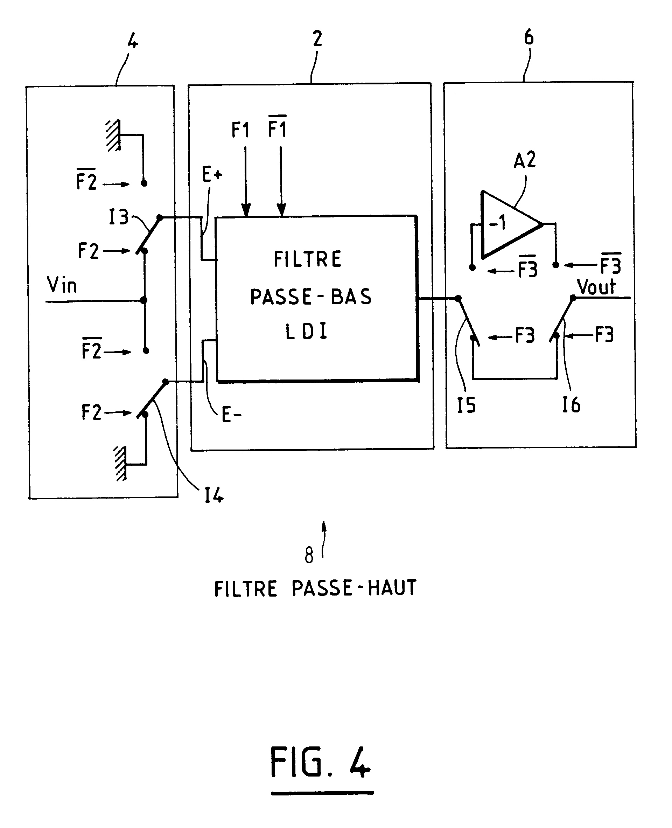

Sur la figure 4, on a représenté une vue symbolique du dispositif 8 selon l'invention comprenant un filtre passe-bas du type LDI auquel sont ajoutés des moyens amont 4 de commutation et des moyens aval 6 de commutation pour obtenir un filtre échantillonné à capacités commutées de type passe-haut.

Le filtre passe-bas LDI noté 2, identique à la cellule de base 2 décrite en référence à la figure 2, est commandé par le signal d'horloge de fréquence $F_1$.

En amont du module 2 sont placés les moyens amont de commutation 4 identiques aux moyens amont 4 de commutation décrits en référence à la figure 2, tandis qu'en aval du module 2 sont placés les moyens aval 6 de commutation, identiques aux moyens aval 6 de commutation décrits en référence à la figure 2.

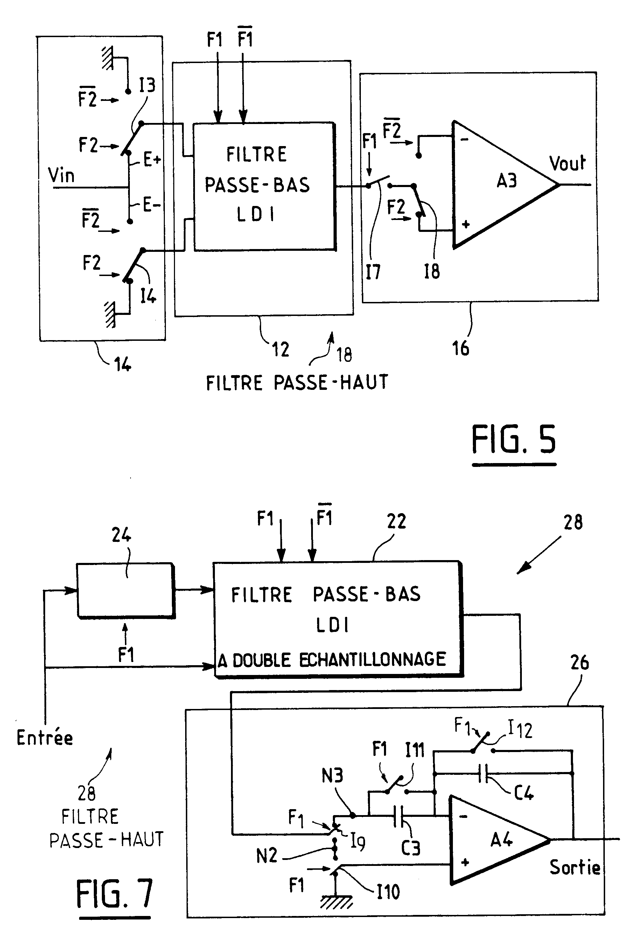

Sur la figure 5, on a représenté une variante du dispositif de l'invention.

Dans cette variante, les moyens aval 6 de commutation décrits en référence à la figure 4 sont remplacés par des moyens aval 16 comprenant un étage échantillonneur-bloqueur 16.

L'étage échantillonneur-bloqueur 16 comprend un interrupteur $I_8$ relié à la sortie de la cellule de base 12 via un autre interrupteur $I_7$ dont l'ouverture et la fermeture sont commandées par le signal d'horloge de fréquence $F_1$.

L'interrupteur $I_8$ est commandé par le signal d'horloge de fréquence $F_2$. Par exemple, pendant l'état haut $F_2$, l'interrupteur $I_8$ établit une liaison électrique entre l'entrée positive de l'amplificateur opérationnel $A_3$ et l'interrupteur $I_7$ tandis que pendant l'état bas $\overline{F_2}$, l'interrupteur $I_8$ établit une liaison électrique entre l'entrée négative de l'amplificateur différentiel $A_3$ et l'interrupteur $I_7$.

La sortie de l'amplificateur différentiel $A_3$ délivre le signal de sortie $V_{out}$ du dispositif 18 agencé alors en filtre échantillonné à capacités commutées de type passe-haut. Les moyens amont 14 sont identiques à ceux décrits en référence à la figure 4.

L'étage échantillonneur-bloqueur 16 échantillonne le signal de sortie du filtre passe-bas 12 pendant $\overline{F_1}$ et bloque celui-ci pendant $F_1$. Pendant $F_2$, l'entrée non inverseuse de l'amplificateur opérationnel $A_3$ est active tandis que pendant $\overline{F_2}$, l'en-

trée inverseuse de $A_3$ est active, il en résulte une inversion de polarité du signal de sortie $V_{out}$ pendant $\overline{F_2}$.

Cette variante du dispositif de l'invention permet ainsi de supprimer le signal d'horloge de fréquence $F_3$ commandant l'amplificateur opérationnel $A_2$ des moyens aval 4 décrits en référence aux figures 2 et 4.

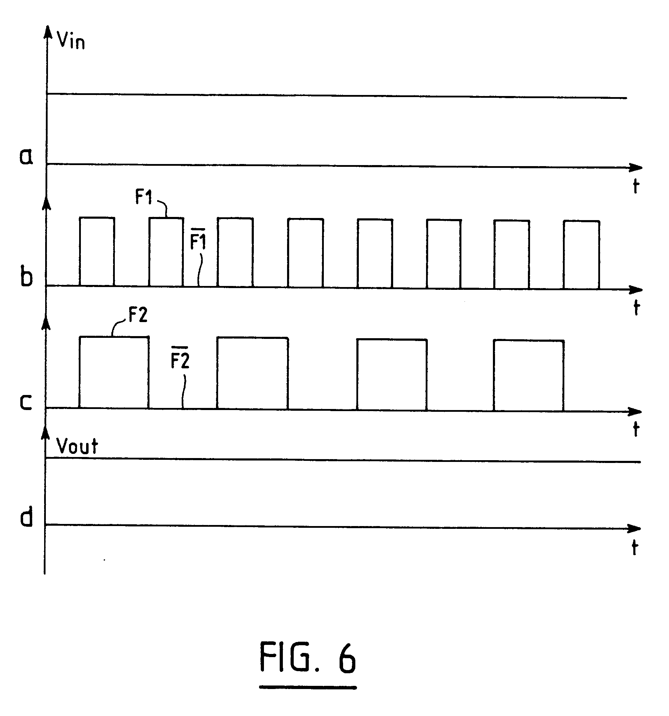

Sur la figure 6 on a représenté les chronogrammes illustrant le fonctionnement du filtre passe-haut décrit en référence à la figure 5. Les parties a, b, c et d de la figure 6 sont respectivement identiques aux parties a, b, c et g de la figure 3 puisque dans la variante de l'invention décrite en référence à la figure 5 seuls les moyens aval de commutation 16 sont différents des moyens aval de commutation 4 décrits en référence aux figures 2 et 4.

On voit que dans cette figure 6 il n'y a plus le signal d'horloge $F_3$ puisque les moyens aval 16 de commutation sont commandés maintenant par les signaux d'horloge $F_2$ et $F_1$ qui inversent pendant $F_2$ la polarité du signal de sortie du filtre passe-bas LDI 12 échantillonné pendant l'état bas $\overline{F_1}$.

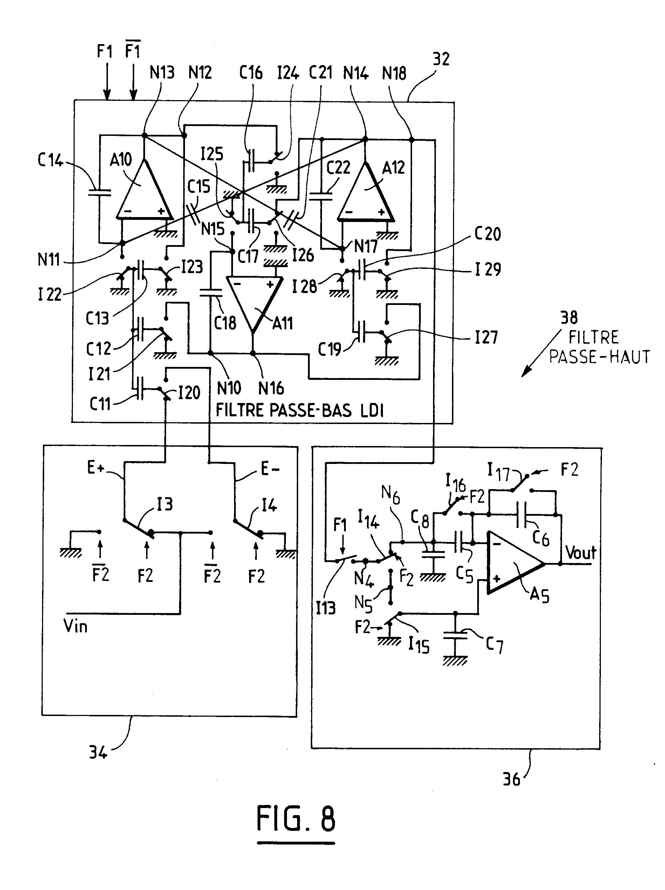

Sur la figure 7, on a représenté une autre variante du dispositif de l'invention. Dans cette variante, la cellule de base 22 agencée en filtre échantillonné à capacités commutées de type passe-bas appliquant la transformation LDI est maintenant à double échantillonnage.

Les moyens aval 26 sont agencés en étage échantillonneurbloqueur comme les moyens aval 16 de commutation décrits en référence à la figure 5. L'étage échantillonneur-bloqueur 26 comprend tout d'abord un interrupteur $I_9$ relié au signal de sortie de la cellule de base 22. L'ouverture et la fermeture de l'interrupteur $I_9$ sont commandées par le signal d'horloge de fréquence $F_1$.

Pendant $\overline{F_1}$, l'interrupteur $I_9$ établit une liaison électrique entre ladite sortie de la cellule de base 22 et un noeud $N_3$ tandis que pendant $F_1$, l'interrupteur $I_9$ établit une liaison électrique entre ladite sortie et un noeud $N_2$.

Un interrupteur $I_{10}$ est relié à l'entrée positive d'un amplificateur différentiel $A_4$. L'ouverture et la fermeture de l'interrupteur $I_{10}$ sont commandées par le signal d'horloge de fréquence $F_1$. Pendant $F_1$, l'interrupteur $I_{10}$ établit une liaison entre ladite entrée positive et la masse tandis que pendant $\overline{F_1}$, l'interrupteur $I_{10}$ établit une liaison entre ladite entrée positive de l'amplificateur différentiel $A_4$ et le second noeud $N_2$. Une capacité $C_3$ est placée entre le noeud $N_3$ et l'entrée négative de l'amplificateur opérationnel $A_4$. La capacité $C_3$ a en parallèle un interrupteur $I_{11}$ propre à établir pendant $\overline{F_1}$ une liaison électrique entre les deux armatures de la capacité $C_3$.

L'étage échantillonneur-bloqueur 26 comprend enfin une capacité $C_4$ placée entre l'entrée négative de l'amplificateur opérationnel $A_4$ et la sortie dudit amplificateur opérationnel $A_4$ délivrant le signal de sortie du dispositif 28. La capacité $C_4$ a en parallèle un interrupteur $I_{12}$ propre à établir pendant $\overline{F_1}$ une liaison électrique entre les deux armatures de la capacité $C_4$.

A chaque état haut $F_1$, le signal de sortie du filtre passe-bas 22 circule via la capacité $C_3$, la borne inverseuse de $A_4$ et la capacité $C_4$. Le signal de sortie $V_{out}$ du dispositif 28 est donc proportionnel au signal de sortie du filtre passe-bas 22 avec un coefficient de proportionnalité négatif égal à $C_3/C_4$.

A chaque état bas $\overline{F_1}$, le signal de sortie du filtre passe-bas 22 circule via la borne non inverseuse de $A_4$. Le signal de sortie $V_{out}$ du dispositif 28 est donc égal au signal de sortie du filtre passe-bas 22.

Les moyens amont 24 de commutation sont également agencés en étage échantillonneur-bloqueur. L'étage 24 joue le même rôle que les moyens 4 et 14 précédents en échantillonnant le signal d'entrée $V_{in}$ pendant $F_1$ et en le bloquant pendant $\overline{F_1}$.

Sur la figure 8, on a représenté un dispositif de filtre échantillonné à capacités commutées du type passe-haut elliptique d'ordre 3. Le dispositif 38 comprend un filtre 32 passe-bas d'ordre 3, c'est-à-dire comprenant trois amplificateurs opérationnels, auxquels sont à ajouter des moyens amont 34 de commutation et des moyens aval 36 de commutation.

La cellule de base 32 est échantillonnée à la fréquence $F_1$, sans double échantillonnage.

A l'entrée $E^+$ de la cellule de base, on trouve trois capacités $C_{11}$, $C_{12}$ et $C_{13}$. Un interrupteur $I_{20}$, placé en amont d'une armature de la capacité $C_{11}$ commande, sous le signal de l'horloge $F_1$, l'établissement d'une liaison électrique entre l'entrée $E^+$ de la cellule 32 et ladite armature de la capacité $C_{11}$ ou entre ladite entrée $E^+$ et l'entrée négative $E^-$ de la cellule 32.

Un interrupteur $I_{21}$, placé en amont d'une armature de la capacité $C_{12}$ commande, sous le signal d'horloge $F_1$, l'établissement d'une liaison électrique entre ladite armature de $C_{12}$ et la masse ou entre ladite armature de $C_{12}$ et un noeud $N_{10}$. L'autre armature de la capacité $C_{12}$ est reliée à une des armatures de la capacité $C_{13}$ qui est elle-même reliée à un interrupteur $I_{22}$, l'autre des armatures de $C_{13}$ étant reliée à un interrupteur $I_{23}$.

L'interrupteur $I_{22}$ commande, sous le signal d'horloge $F_1$, l'établissement d'une liaison électrique entre l'une des armatures de $C_{13}$ et la masse ou entre ladite armature de $C_{13}$ et un noeud $N_{11}$.

L'interrupteur $I_{23}$ commande, sous le signal d'horloge $F_1$, l'établissement d'une liaison électrique entre l'autre des armatures de $C_{13}$ et la masse ou entre ladite armature de $C_{13}$ et un noeud $N_{12}$.

Le noeud $N_{11}$ est relié tout d'abord à une armature d'une capacité $C_{14}$ dont l'autre armature est reliée à un noeud $N_{13}$, ensuite à une autre armature d'une capacité $C_{15}$ et enfin à l'entrée négative d'un amplificateur différentiel $A_{10}$. L'entrée positive de l'amplificateur différentiel $A_{10}$ est mise à la masse, tandis que la sortie dudit opérateur $A_{10}$ est reliée au noeud $N_{13}$. L'autre armature de la capacité $C_{15}$ est reliée à un noeud $N_{14}$.

Le noeud $N_{12}$ est relié à un interrupteur $I_{24}$ commandant, sous le signal d'horloge $F_1$, l'établissement d'une liaison électrique entre le noeud $N_{12}$ et une armature d'une capacité $C_{16}$ ou entre ladite armature de $C_{16}$ et la masse. L'autre armature de la capacité $C_{16}$ est reliée à une capacité $C_{17}$ dont l'une des armatures est reliée à un interrupteur $I_{25}$ et dont l'autre des armatures est reliée à un interrupteur $I_{26}$.

L'interrupteur $I_{25}$ commande, sous le signal de l'horloge $F_1$, l'établissement d'une liaison électrique entre l'une des armatures de $C_{17}$ et un noeud $N_{15}$ ou entre ladite armature de $C_{17}$ et la masse.

L'interrupteur $I_{26}$ commande, sous le signal d'horloge $F_1$, l'établissement d'une liaison électrique entre l'autre des armatures de $C_{17}$ et le noeud $N_{14}$ ou entre ladite armature $C_{17}$ et la masse.

Le noeud $N_{15}$ est relié d'une part au noeud $N_{10}$ via une capacité $C_{18}$ et d'autre part à l'entrée négative d'un amplificateur différentiel $A_{11}$ dont l'entrée positive est à la masse. La sortie de l'amplificateur opérationnel $A_{11}$ est reliée à un noeud $N_{16}$ auquel est relié le noeud $N_{10}$ et un interrupteur $I_{27}$.

L'interrupteur $I_{27}$ commande, sous le signal de l'horloge $F_1$, l'établissement d'une liaison électrique entre le noeud $N_{16}$ et une armature d'une capacité $C_{19}$ ou entre ladite armature de $C_{19}$ et la masse.

L'autre des armatures de $C_{19}$ est reliée à l'une des armatures de $C_{20}$ qui est reliée elle-même à un interrupteur $I_{28}$, l'autre des armatures de $C_{20}$ étant reliée à l'interrupteur $I_{29}$.

L'interrupteur $I_{28}$ commande, sous le signal de l'horloge $F_1$, l'établissement d'une liaison électrique entre l'une des armatures de $C_{20}$ et un noeud $N_{17}$ ou entre ladite armature de $C_{20}$ et la masse.

L'interrupteur $I_{29}$ commande, sous le signal de l'horloge $F_1$, l'établissement d'une liaison électrique entre l'autre des armatures de $C_{20}$ et un noeud $N_{18}$ ou entre ladite armature de $C_{20}$ et la masse.

Le noeud $N_{17}$ est relié tout d'abord au noeud $N_{13}$ via une capacité $C_{21}$, ensuite au noeud $N_{14}$ via une capacité $C_{22}$ et enfin à l'entrée négative d'un amplificateur différentiel $A_{12}$ dont l'entrée positive est à la masse. La sortie de l'amplificateur différentiel $A_{12}$ est reliée au noeud $N_{14}$.

Les moyens amont 34 de commutation sont identiques aux moyens 4 décrits en référence aux figures 2 et 4.

Les moyens aval 36 de commutation ont une structure très proche de celle des moyens aval décrits en référence à la figure 7. Ainsi, les interrupteurs $I_{14}$, $I_{15}$, $I_{16}$ et $I_{17}$ accompagnés des noeuds $N_5$ et $N_6$ sont identiques aux interrupteurs respectivement $I_9$, $I_{10}$, $I_{11}$ et $I_{12}$, accompagnés des noeuds $N_3$ et $N_4$, décrits en référence à la figure 7. D'une façon similaire les capacités $C_5$ et $C_6$ sont identiques aux capacités respectivement $C_3$ et $C_4$. Enfin, l'amplificateur opérationnel $A_5$ est identique à l'amplificateur $A_4$. Toutefois, puisque le dispositif de l'invention est un filtre à simple échantillonnage, les moyens aval 36 comprennent des capacités supplémentaires $C_7$ et $C_8$ qui maintiennent la tension à leurs bornes pendant l'état de repos de l'échantillonnage du filtre.

La capacité $C_7$ possède une armature reliée au sixième noeud $N_6$ et une autre armature reliée à la masse. La capacité $C_8$ posséde une armature reliée à l'entrée positive de l'amplificateur différentiel $A_5$ et une autre armature reliée à la masse.

L'ouverture et la fermeture des interrupteurs $I_{14}$, $I_{15}$, $I_{16}$ et $I_{17}$ sont commandées par le signal d'horloge de fréquence $F_2$, tandis que celles de l'interrupteur $I_{13}$ reliant, via le noeud $N_4$, l'interrupteur $I_{14}$ à la sortie de la cellule de base 32 sont commandées par $F_1$.

A chaque état haut $F_1$ et $F_2$, le signal de sortie du filtre passe-bas 32 circule via la capacité $C_5$, la borne inverseuse de $A_5$ et la capacité $C_6$. Le signal de sortie $V_{out}$ du dispositif 38 est donc proportionnel au signal de sortie du filtre passe-bas 32 avec un coefficient de proportionnalité négatif égal à $C_5/C_6$.

A chaque état haut $F_1$ et à chaque état bas $\overline{F_2}$, le signal de sortie du filtre passe-bas 22 circule via la borne non inverseuse de $A_5$. Le signal de sortie $V_{out}$ du dispositif 38 est donc égal au signal de sortie du filtre passe-bas 32.

## Revendications

1. Dispositif du type comprenant au moins une cellule de base (2, 12, 22, 32) agencée en filtre échantillonné à capacités commutées, ainsi qu'une horloge propre à définir deux états différents pour commander l'échantillonnage, caractérisé en ce qu'il comprend :
   - des moyens amont (4, 14, 24, 34) de commutation aptes à inverser la polarité du signal d'entrée de la cellule pendant l'un des deux états; et
   - des moyens aval (6, 16, 26, 36) de commutation aptes à inverser le signal de sortie de la cellule; ce qui permet de transposer la bande de fréquence de filtrage de la cellule.

2. Dispositif selon la revendication 1, caractérisé en ce que la cellule de base (2, 12, 22, 32) est agencée en filtre échantillonné de type passe-bas, le dispositif (8, 18, 28, 38) étant alors un filtre échantillonné de type passe-haut.

3. Dispositif selon la revendication 2, caractérisé en ce que la cellule de base (2) comprend :
   - un premier amplificateur différentiel ($A_1$) dont l'entrée négative est reliée via une première capacité ($C_1$) à la sortie dudit premier amplificateur ($A_1$) délivrant le signal de sortie ($V_{out}$) de la cellule (2) et dont l'entrée positive est à la masse;
   - un premier interrupteur ($I_1$) relié à une armature d'une seconde capacité ($C_2$), ledit premier interrupteur étant propre sur commande de l'horloge à établir une liaison électrique entre ladite seconde capacité ($C_2$) et l'entrée négative du premier amplificateur ($A_1$) ou entre ladite seconde capacité ($C_2$) et la masse; et
   - un second interrupteur ($I_2$) relié à l'autre armature de la seconde capacité ($C_2$), ledit deuxième interrupteur ($I_2$) étant propre sur commande de l'horloge à établir une liaison électrique entre ladite seconde capacité ($C_2$) et la borne positive ($E^+$) de la cellule de base (2) ou entre ladite seconde capacité ($C_2$) et la borne négative ($E^-$) de la cellule (2) recevant le signal d'entrée ($V_{in}$) de la cellule (2).

4. Dispositif selon l'une des revendications précédentes, caractérisé en ce que les moyens amont (4) de commutation comprennent :
   - un troisième interrupteur ($I_3$) relié à la borne positive ($E^+$) de la cellule de base (2), ledit troisième interrupteur ($I_3$) étant propre sur commande de l'horloge à établir une liaison électrique entre ladite borne positive ($E^+$) et la masse ou entre ladite borne positive ($E^+$) et le signal d'entrée ($V_{in}$); et
   - un quatrième interrupteur ($I_4$) relié à la borne négative ($E^+$) de la cellule de base (2), ledit quatrième interrupteur ($I_4$) étant propre sur commande de l'horloge à établir une liaison électrique entre ladite borne négative ($E^-$) et la masse ou entre ladite borne négative ($E^-$) et le signal d'entrée ($V_{in}$).

5. Dispositif selon l'une quelconque des revendications précédentes, caractérisé en ce que les moyens aval (6) de commutation comprennent :
   - un second amplificateur différentiel ($A_2$), de type inverseur, propre sur commande de l'horloge à inverser la polarité du signal de sortie ($V_{out}$) du dispositif (8) pendant l'autre des deux états;
   - un cinquième interrupteur ($I_5$) relié à la sortie du premier amplificateur opérationnel ($A_1$) de la cellule (2), ledit cinquième interrupteur ($I_5$) étant propre sur commande de l'horloge à établir une liaison électrique entre ladite sortie du premier amplificateur différentiel ($A_1$) et un premier noeud ($N_1$) ou entre ladite sortie du premier amplificateur différentiel ($A_1$) et l'entrée du second amplificateur différentiel ($A_2$); et
   - un sixième interrupteur ($I_6$) relié à la sortie ($V_{out}$) du dispositif (8), ledit sixième interrupteur ($I_6$) étant propre sur commande de l'horloge à établir une liaison électrique entre ladite sortie ($V_{out}$) du dispositif (8) et la sortie du second amplificateur différentiel ($A_2$) ou entre ladite sortie ($V_{out}$) du dispositif (8) et le premier noeud ($N_1$).

6. Dispositif selon l'une quelconque des revendications 1 à 3, caractérisé en ce que les moyens aval (16) de commutation sont agencés en étage échantillonneur-bloqueur, l'étage comprenant un huitième interrupteur ($I_8$) relié à la sortie de la cellule de base (12), via un septième interrupteur ($I_7$) propre sur commande à établir une liaison électrique entre la sortie de la cellule (12) et le huitième interrupteur ($I_8$), ledit huitième interrupteur ($I_8$) étant propre sur commande de l'horloge à établir une liaison électrique entre ledit septième interrupteur ($I_7$) et l'entrée négative d'un troisième amplificateur différentiel ($A_3$) ou entre ledit septième interrupteur ($I_7$) et l'entrée positive dudit troisième amplificateur différentiel ($A_3$), le signal de sortie ($V_{out}$) du dispositif (18) étant obtenu à la sortie du troisième amplificateur différentiel ($A_3$).

7. Dispositif selon la revendication 1, caractérisé en ce que la cellule de base (22) est à double échantillonnage.

8. Dispositif selon la revendication 7, caractérisé en ce que les moyens amont (24) de commutation sont agencés en étage échantillonneur-bloqueur.

**9.** Dispositif selon l'une des revendications 1 à 4, caractérisé en ce que les moyens aval (26) de commutation comprennent :

- un neuvième interrupteur (I$_9$) relié à la sortie de la cellule de base (22), ledit neuvième interrupteur (I$_9$) étant propre sur commande de l'horloge à établir une liaison électrique entre ladite sortie de la cellule (22) et un second noeud (N$_2$) ou entre ladite sortie de la cellule (22) et un troisième noeud (N$_3$);
- un dixième interrupteur (I$_{10}$) relié à l'entrée positive d'un quatrième amplificateur différentiel (A$_4$), ledit dixième interrupteur (I$_{10}$) étant propre sur commande de l'horloge à établir une liaison électrique entre ladite entrée positive et la masse ou entre ladite entrée positive et le second noeud (N$_2$);
- une troisième capacité (C$_3$) placée entre le troisième noeud (N$_3$) et l'entrée négative du quatrième amplificateur opérationnel (A$_4$), ladite troisième capacité (C$_3$) ayant en parallèle un onzième interrupteur (I$_{11}$) propre sur commande de l'horloge à établir une liaison électrique entre les deux armatures de la troisième capacité (C$_3$);
- une quatrième capacité (C$_4$) placée entre l'entrée négative du quatrième amplificateur opérationnel (A$_4$) et la sortie dudit quatrième amplificateur (A$_4$) délivrant le signal de sortie (V$_{out}$) du dispositif (28), ladite quatrième capacité (C$_4$) ayant en parallèle un douzième interrupteur (I$_{12}$) propre sur commande de l'horloge à établir une liaison électrique entre les deux armatures de la quatrième capacité (C$_4$).

**10.** Dispositif selon l'une des revendications 1 à 4, caractérisé en ce que les moyens aval (36) de commutation comprennent :

- un treizième interrupteur (I$_{13}$) relié à la sortie de la cellule (32), ledit treizième interrupteur (I$_{13}$) étant propre sur commande de l'horloge à établir une liaison électrique entre ladite sortie de la cellule (32) et un quatrième noeud (N$_4$);
- un quatorzième interrupteur (I$_{14}$) relié au quatrième noeud (N$_4$), ledit quatorzième interrupteur (I$_{14}$) étant propre sur commande de l'horloge à établir une liaison électrique entre ledit quatrième noeud (N$_4$) et un cinquième noeud (N$_5$) ou entre ledit quatrième noeud (N$_4$) et un sixième noeud (N$_6$);
- un quinzième interrupteur (I$_{15}$) relié à l'entrée positive d'un cinquième amplificateur différentiel (A$_5$), ledit quinzième interrupteur (I$_{15}$) étant propre sur commande de l'horloge à établir une liaison électrique entre ladite entrée positive et la masse ou entre ladite entrée positive et le cinquième noeud (N$_5$);
- une cinquième capacité (C$_5$) placée entre le sixième noeud (N$_6$) et l'entrée négative du cinquième amplificateur opérationnel (A$_5$), ladite cinquième capacité (C$_5$) ayant en parallèle un seizième interrupteur (I$_{16}$) propre sur commande de l'horloge à établir une liaison électrique entre les deux armatures de la cinquième capacité (C$_5$);
- une sixième capacité (C$_6$) placée entre l'entrée négative du cinquième amplificateur opérationnel (A$_5$) et la sortie dudit cinquième amplificateur (A$_5$) délivrant le signal de sortie (V$_{out}$) du dispositif (28), ladite sixième capacité (C$_6$) ayant en parallèle un dix-septième interrupteur (I$_{17}$) propre sur commande de l'horloge à établir une liaison électrique entre les deux armatures de la sixième capacité (C$_6$);
- une septième capacité (C$_7$) dont une armature est reliée au sixième noeud (N$_6$) et dont l'autre armature est reliée à la masse; et
- une huitième capacité (C$_8$) dont une armature est reliée à l'entrée positive du cinquième amplificateur différentiel (A$_5$) et dont l'autre armature est reliée à la masse.

**Claims**

**1.** Device of the type comprising at least one basic filter section (2, 12, 22, 32) arranged as a sampling filter with switched capacitors, as well as a clock designed to define two different states to control the sampling, characterised in that it comprises:

- input switching means (4, 14, 24, 34) suitable for inverting the polarity of the input signal of the filter section during one of the two states; and
- output switching means (6, 16, 26, 36) suitable for inverting the output signal of the filter section; which enables the filter frequency band of the filter section to be translated.

**2.** Device according to claim 1, characterised in that the basic filter section (2, 12, 22, 32) is arranged as a low-pass type of sampling filter, the device (8, 18, 28, 38) then being a high-pass type of sampling filter.

3. Device according to claim 2, characterised in that the basic filter section (2) comprises:

- a first differential amplifier ($A_1$) whose negative input is connected via a first capacitor ($C_1$) to the output of the said first amplifier ($A_1$) supplying the output signal ($V_{out}$) of the filter section (2) and whose positive input is earthed;
- a first switch ($I_1$) connected to one plate of a second capacitor ($C_2$), the said first switch being designed, under the control of the clock, to make an electrical connection between the said second capacitor ($C_2$) and the negative input of the first amplifier ($A_1$) or between the said second capacitor ($C_2$) and earth; and
- a second switch ($I_2$) connected to the other plate of the second capacitor ($C_2$), the said second switch ($I_2$) being designed, under the control of the clock, to make an electrical connection between the said second capacitor ($C_2$) and the positive terminal ($E^+$) of the basic filter section (2) or between the said second capacitor ($C_2$) and the negative terminal ($E^-$) of the filter section (2) receiving the input signal ($V_{in}$) of the filter section (2).

4. Device according to one of the preceding claims, characterised in that the input switching means (4) comprise:

- a third switch ($I_3$) connected to the positive terminal ($E^+$) of the basic filter section (2), the said third switch ($I_3$) being designed, under the control of the clock, to make an electrical connection between the said positive terminal ($E^+$) and earth or between the said positive terminal ($E^+$) and the input signal ($V_{in}$); and
- a fourth switch ($I_4$) connected to the negative terminal ($E^-$) of the basic filter section (2), the said fourth switch ($I_4$) being designed, under the control of the clock, to make an electrical connection between the said negative terminal ($E^-$) and earth or between the said negative terminal ($E^-$) and the input signal ($V_{in}$).

5. Device according to any one of the preceding claims, characterised in that the output switching means (6) comprise:

- a second differential amplifier ($A_2$) of the inverting type, being designed, under the control of the clock, to invert the polarity of the output signal ($V_{out}$) of the device (8) during the other of the two states;
- a fifth switch ($I_5$) connected to the output of the first operational amplifier ($A_1$) of the filter section (2), the said fifth switch ($I_5$) being designed, under the control of the clock, to make an electrical connection between the said output of the first differential amplifier ($A_1$) and a first node ($N_1$) or between the said output of the first differential amplifier ($A_1$) and the input of the second differential amplifier ($A_2$); and
- a sixth switch ($I_6$) connected to the output ($V_{out}$) of the device (8), the said sixth switch ($I_6$) being designed, under the control of the clock, to make an electrical connection between the said output ($V_{out}$) of the device (8) and the output of the second differential amplifier ($A_2$) or between the said output ($V_{out}$) of the device (8) and the first node ($N_1$).

6. Device according to any one of the claims 1 to 3, characterised in that the output switching means (16) are arranged as a sample-and-hold stage, the stage containing an eighth switch ($I_8$) connected to the output of the basic filter section (12), via a seventh switch ($I_7$) designed, under control, to make an electrical connection between the output of the filter section (12) and the eighth switch ($I_8$), the said eighth switch ($I_8$) being designed, under the control of the clock, to make an electrical connection between the said seventh switch ($I_7$) and the negative input of a third differential amplifier ($A_3$) or between the said seventh switch ($I_7$) and the positive input of the said third differential amplifier ($A_3$), the output signal ($V_{out}$) of the device (18) being obtained from the output of the third differential amplifier ($A_3$).

7. Device according to claim 1, characterised in that the basic filter section (22) is of the double sampling type.

8. Device according to claim 7, characterised in that the input switching means (24) are arranged as a sample-and-hold stage.

9. Device according to one of the claims 1 to 4, characterised in that the output switching means (26) comprise:

- a ninth switch ($I_9$) connected to the output of the basic filter section (22), the said ninth switch ($I_9$) being designed, under the control of the clock, to make an electrical connection between the said output of the filter section (22) and a second node ($N_2$) or between the said output of the filter section (22) and a third node ($N_3$);

- a tenth switch ($I_{10}$) connected to the positive input of a fourth differential amplifier ($A_4$), the said tenth switch ($I_{10}$) being designed, under the control of the clock, to make an electrical connection between the said positive input and earth or between the said positive input and the second node ($N_2$);
- a third capacitor ($C_3$) placed between the third node ($N_3$) and the negative input of the fourth operational amplifier ($A_4$), the said third capacitor ($C_3$) being in parallel with an eleventh switch ($I_{11}$) being designed, under the control of the clock, to make an electrical connection between the two plates of the third capacitor ($C_3$);
- a fourth capacitor ($C_4$) placed between the negative input of the fourth operational amplifier ($A_4$) and the output of the said fourth amplifier ($A_4$) supplying the output signal ($V_{out}$) of the device (28), the said fourth capacitor ($C_4$) having in parallel a twelfth switch ($I_{12}$) being designed, under the control of the clock, to make an electrical connection between the two plates of the fourth capacitor ($C_4$).

10. Device according to one of the claims 1 to 4, characterised in that the output switching means (36) comprise:
- a thirteenth switch ($I_{13}$) connected to the output of the filter section (32), the said thirteenth switch ($I_{13}$) being designed, under the control of the clock, to make an electrical connection between the said output of the filter section (32) and a fourth node ($N_4$);
- a fourteenth switch ($I_{14}$) connected to the fourth node ($N_4$), the said fourteenth switch ($I_{14}$) being designed, under the control of the clock, to make an electrical connection between the said fourth node ($N_4$) and a fifth node ($N_5$) or between the said fourth node ($N_4$) and a sixth node ($N_6$);
- a fifteenth switch ($I_{15}$) connected to the positive input of a fifth differential amplifier ($A_5$), the said fifteenth switch ($I_{15}$) being designed, under the control of the clock, to make an electrical connection between the said positive input and earth or between the said positive input and the fifth node ($N_5$);
- a fifth capacitor ($C_5$) placed between the sixth node ($N_6$) and the negative input of the fifth operational amplifier ($A_5$), the said fifth capacitor ($C_5$) being in parallel

with a sixteenth switch ($I_{16}$) being designed, under the control of the clock, to make an electrical connection between the two plates of the fifth capacitor ($C_5$);
- a sixth capacitor ($C_6$) placed between the negative input of the fifth operational amplifier ($A_5$) and the output of the said fifth amplifier ($A_5$) supplying the output signal ($V_{out}$) of the device (28), the said sixth capacitor ($C_6$) being in parallel with a seventeenth switch ($I_{17}$) being designed, under the control of the clock, to make an electrical connection between the two plates of the sixth capacitor ($C_6$);
- a seventh capacitor ($C_7$), one of whose plates is connected to the sixth node ($N_6$) and whose other plate is connected to earth; and
- an eighth capacitor ($C_8$), one of whose plates is connected to the positive input of the fifth differential amplifier ($A_5$) and whose other plate is connected to earth.

**Patentansprüche**

1. Sampling-Filtereinrichtung mit zumindest einer Grundzelle (2, 12, 22, 32) als Sampling-Filtereinrichtung mit geschalteten Kapazitäten sowie mit einem eigenen Taktgeber zur Definition von zwei verschiedenen Zuständen zur Steuerung der Abtastung,
**dadurch gekennzeichnet,**
daß diese folgende Elemente umfaßt:
- vorgeschaltete Umschaltelemente (4, 14, 24, 34) zur Umkehrung der Polarität des Eingangssignals der Zelle während eines der Zustände; und
- nachgeschaltete Umschaltelemente (6, 16, 26, 36) zur Umkehrung des Ausgangssignals der Zelle, wodurch das Filterfrequenzband der Zelle umgeschaltet werden kann.

2. Sampling-Filtereinrichtung nach Anspruch 1, dadurch gekennzeichnet, daß die Grundzelle (2, 12, 22, 32) als Sampling-Tiefpaßfilter aufgebaut ist, wobei es sich bei der Einrichtung (8, 18, 28, 38) somit um einen Sampling-Hochpaßfilter handelt.

3. Sampling-Filtereinrichtung nach Anspruch 2, dadurch gekennzeichnet, daß die Grundzelle ( 2) folgende Elemente umfaßt:
- einen ersten Differenzverstärker ($A_1$), dessen negativer Eingang über eine erste Kapazität ($C_1$) mit dem Ausgang des genannten ersten Verstärkers ($A_1$) ver-

bunden ist, der das Ausgangssignal (V_{out}) der Zelle (2) liefert und dessen positiver Eingang an Masse liegt;

- einen ersten Unterbrecher (I_1), der mit einem Belag einer zweiten Kapazität (C_2) verbunden ist, wobei der erste Unterbrecher auf Steuerung des Taktgebers eine elektrische Verbindung zwischen der genannten zweiten Kapazität (C_2) und dem negativen Eingang des ersten Verstärkers (A_1) oder zwischen der genannten zweiten Kapazität (C_2) und der Masse herstellt; und

- einen zweiten Unterbrecher (I_2), der mit dem anderen Belag der zweiten Kapazität (C_2) verbunden ist, wobei der genannte zweite Unterbrecher auf Steuerung des Taktgebers eine elektrische Verbindung zwischen der genannten zweiten Kapazität (C_2) und der positiven Klemme (E^+) der Grundzelle (2) oder zwischen der genannten zweiten Kapazität (C_2) und der negativen Klemme (E^-) der Zelle (2) herstellt, die das Eingangssignal (V_{in}) der Zelle (2) erhält.

4. Sampling-Filtereinrichtung nach einem der vorgenannten Ansprüche, dadurch gekennzeichnet, daß die vorgeschalteten Umschaltelemente folgende Elemente umfassen:
- einen dritten Unterbrecher (I_3), der mit der positiven Klemme (E^+) der Grundzelle (2) verbunden ist, wobei der dritte Unterbrecher (I_3) nach der Steuerung des Taktgebers eine elektrische Verbindung zwischen der genannten positiven Klemme (E^+) und der Masse oder zwischen der genannten positiven Klemme (E^+) und dem Eingangssignal (V_{in}) herstellt; und
- ein vierter Unterbrecher (I_4), der mit der negativen Klemme (E^-) der Grundzelle verbunden ist, wobei der genannte vierte Unterbrecher (I_4) auf Steuerung des Taktgebers eine elektrische Verbindung zwischen der genannten negativen Klemme (E^-) und der Masse oder zwischen der genannten negativen Klemme (E^-) und dem Eingangssignal (V_{in}) herstellt.

5. Sampling-Filtereinrichtung nach einem der vorgenannten Ansprüche, dadurch gekennzeichnet, daß die nachgeschalteten Umschaltelemente (6) folgende Elemente umfassen:
- einen zweiten Differenzverstärker (A_2) vom Umkehrtyp, der auf Steuerung des Taktgebers die Polarität des Ausgangssignals (V_{out}) der Einrichtung (8) während des anderen der beiden Zustände umkehrt;

- einen fünften Unterbrecher (I_5), der mit dem Ausgang des ersten Operationsverstärkers (A_1) der Zelle (2) verbunden ist, wobei der genannte fünfte Unterbrecher (I_5) auf Steuerung des Taktgebers eine elektrische Verbindung zwischen dem genannten Ausgang des ersten Differenzverstärkers (A_1) und einem ersten Knoten (N_1) oder zwischen dem genannten Ausgang des ersten Differenzverstärkers (A_1) und dem Eingang des zweiten Differenzverstärkers (A_2) herstellt; und

- einen sechsten Unterbrecher (I_6), der mit dem Ausgang (V_{out}) der Einrichtung (8) verbunden ist, wobei der sechste Unterbrecher (I_6) auf Steuerung des Taktgebers eine elektrische Verbindung zwischen dem genannten Ausgang (V_{out}) der Einrichtung (8) und dem Ausgang des zweiten Differenzverstärkers (A_2) oder zwischen dem genannten Ausgang (V_{out}) der Einrichtung (8) und dem ersten Knoten (N_1) herstellt.

6. Sampling-Filtereinrichtung nach einem der Ansprüche 1 bis 3, dadurch gekennzeichnet, daß die nachgeschalteten Umschaltelemente (16) als Sampling-Blockierstufe ausgeführt sind, wobei die Stufe einen achten Unterbrecher (I_8) umfaßt, der mit dem Ausgang der Grundzelle (12) über einen siebenten Unterbrecher (I_7) verbunden ist, der auf Steuerung eine elektrische Verbindung zwischen dem Ausgang der Zelle (12) und dem achten Unterbrecher (I_8) herstellt, wobei auf Steuerung des Taktgebers eine elektrische Verbindung zwischen dem genannten siebenten Unterbrecher (I_7) und dem negativen Eingang eines dritten Differenzverstärkers (A_3) oder zwischen dem genannten siebenten Unterbrecher (I_7) und dem positiven Eingang des genannten dritten Differenzverstärkers (A_3) herstellt, wobei das Ausgangssignal (V_{out}) der Einrichtung (18) am Ausgang des dritten Differenzverstärkers (A_3) anliegt.

7. Sampling-Filtereinrichtung nach Anspruch 1, dadurch gekennzeichnet, daß die Grundzelle (22) mit doppelter Abtastung arbeitet.

8. Sampling-Filtereinrichtung nach Anspruch 7, dadurch gekennzeichnet,

daß die vorgeschalteten Umschaltungselemente (24) als Sampling-Blockierstufe ausgeführt sind

9. Sampling-Filtereinrichtung nach einem der Ansprüche 1 bis 4,
dadurch gekennzeichnet,
daß die nachgeschalteten Umschaltelemente (26) folgende Elemente umfassen:

- einen neunten Unterbrecher ($I_9$), der mit dem Ausgang der Grundzelle (22) verbunden ist, wobei der genannte neunte Unterbrecher ($I_9$) auf Steuerung des Taktgebers eine elektrische Verbindung zwischen dem genannten Ausgang der Zelle (22) und einem zweiten Knoten ($N_2$) oder zwischen dem genannten Ausgang der Zelle (22) und einem dritten Knoten ($N_3$) herstellt;
- ein zehnter Unterbrecher ($I_{10}$), mit dem positiven Eingang eines vierten Differenzverstärkers ($A_4$) verbunden, wobei der genannte zehnte Unterbrecher ($I_{10}$) auf Steuerung des Taktgebers eine elektrische Verbindung zwischen dem genannten positiven Eingang und der Masse oder zwischen dem genannten positiven Eingang und dem zweiten Knoten ($N_2$) herstellt;
- eine dritte Kapazität ($C_3$) zwischen dem dritten Knoten ($N_3$) und dem negativen Eingang des vierten Operationsverstärkers ($A_4$), wobei die dritte Kapazität ($C_3$) parallel einen elften Unterbrecher ($I_{11}$) umfaßt, der auf Steuerung des Taktgebers eine elektrische Verbindung zwischen den beiden Belägen der dritten Kapazität ($C_3$) herstellt;
- eine vierte Kapazität ($C_4$) zwischen dem negativen Eingang des vierten Operationsverstärkers ($A_4$) und dem Ausgang des genannten vierten Verstärkers ($A_4$), der das Ausgangssignal ($V_{out}$) der Einrichtung (28) liefert, wobei die vierte Kapazität ($C_4$) parallel einen zwölften Unterbrecher ($I_{12}$) umfaßt, der nach Steuerung des Taktgebers eine elektrische Verbindung zwischen den beiden Belägen der vierten Kapazität ($C_4$) herstellt.

10. Sampling-Filtereinrichtung nach einem der Ansprüche 1 bis 4,
dadurch gekennzeichnet,
daß die nachgeschalteten Umschaltungselemente (36) folgende Elemente umfassen:

- einen dreizehnten Unterbrecher ($I_{13}$), mit dem Ausgang der Zelle (32) verbunden, wobei der dreizehnte Unterbrecher ($I_{13}$) auf Steuerung des Taktgebers eine elektrische Verbindung zwischen dem genannten Ausgang der Zelle (32) und einem vierten Knoten ($N_4$) herstellt;
- einen vierzehnten Unterbrecher ($I_{14}$), mit dem vierten Knoten ($N_4$) verbunden, wobei der genannte vierzehnte Unterbrecher auf Steuerung des Taktgebers eine elektrische Verbindung zwischen dem genannten vierten Knoten ($N_4$) und einem fünften Knoten ($N_5$) oder dem genannten vierten Knoten ($N_4$) und einem sechsten Knoten ($N_6$) herstellt;
- einen fünfzehnten Unterbrecher ($I_{15}$), mit dem positiven Eingang eines fünften Differenzverstärkers ($A_5$) verbunden, wobei der fünfzehnte Unterbrecher ($I_{15}$) auf Steuerung des Taktgebers eine elektrische Verbindung zwischen dem genannten positiven Eingang und der Masse oder zwischen dem genannten positiven Eingang und dem fünften Knoten ($N_5$) herstellt;
- eine fünfte Kapazität ($C_5$) zwischen dem sechsten Knoten ($N_6$) und dem negativen Eingang des fünften Operationsverstärkers ($A_5$), wobei die genannte fünfte Kapazität ($C_5$) parallel einen sechzehnten Unterbrecher ($I_{16}$) umfaßt, der auf Steuerung des Taktgebers eine elektrische Verbindung zwischen den beiden Belägen der fünften Kapazität ($C_5$) herstellt;
- eine sechste Kapazität ($C_6$) zwischen dem negativen Eingang des fünften Operationsverstärkers ($A_5$) und dem Ausgang des genannten fünften Verstärkers ($A_5$), der das Ausgangssignal ($V_{out}$) der Einrichtung (28) liefert, wobei die genannte sechste Kapazität ($C_6$) parallel einen siebzehnten Unterbrecher ($I_{17}$) umfaßt, der auf Steuerung des Taktgebers eine elektrische Verbindung zwischen den beiden Belägen der sechsten Kapazität ($C_6$) herstellt;
- eine siebente Kapazität ($C_7$), von der ein Belag mit dem sechsten Knoten ($N_6$) und der andere Belag mit Masse verbunden ist; und
- eine achte Kapazität ($C_8$), von der ein Belag mit dem positiven Eingang des fünften Differenzverstärkers ($A_5$) und der andere Belag mit Masse verbunden ist.

FIG. 1

FIG. 2

FIG. 3

FILTRE PASSE-HAUT

FIG. 4

EP 0 307 276 B1

FILTRE
PASSE-BAS
LDI

Vin

E+

E-

I3

I4

F2

F2

F2

F2

F1

F1

Vout

A3

F2

F2

F1

I7

I8

14

12

18

16

FILTRE PASSE-HAUT

## FIG. 5

FILTRE PASSE-BAS
LDI
A DOUBLE ECHANTILLONNAGE

F1

F1

24

22

28

26

Entrée

F1

28
FILTRE
PASSE-HAUT

## FIG. 7

N3

N2

F1

F1

F1

F1

I9

I10

I11

I12

C3

C4

A4

Sortie

18

FIG. 6

EP 0 307 276 B1

FIG. 8